(19) Europäisches Patentamt / European Patent Office / Office européen des brevets

(11) **EP 3 406 018 B1**

(12) **FASCICULE DE BREVET EUROPEEN**

(45) Date de publication et mention de la délivrance du brevet:
**27.11.2019 Bulletin 2019/48**

(21) Numéro de dépôt: **17706545.5**

(22) Date de dépôt: **19.01.2017**

(51) Int Cl.:
***H02J 13/00*** *(2006.01)*

(86) Numéro de dépôt international:
**PCT/FR2017/050110**

(87) Numéro de publication internationale:
**WO 2017/125684 (27.07.2017 Gazette 2017/30)**

(54) **INSTALLATION DE SURVEILLANCE D'UNE PORTION DE RÉSEAU DE TRANSMISSION DE COURANT ÉLECTRIQUE À HAUTE TENSION**

EINRICHTUNG ZUR ÜBERWACHUNG EINES ABSCHNITTS EINES HOCHSPANNUNGSSTROMVERTEILERNETZES

FACILITY FOR MONITORING A PORTION OF A HIGH-VOLTAGE ELECTRICAL POWER TRANSMISSION NETWORK

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats de validation désignés:
**MA**

(30) Priorité: **21.01.2016 FR 1650467**

(43) Date de publication de la demande:
**28.11.2018 Bulletin 2018/48**

(73) Titulaire: **RTE Réseau de Transport d'Electricité**
**92073 La Défense Cedex (FR)**

(72) Inventeur: **BUHAGIAR, Thierry**
**13009 Marseille (FR)**

(74) Mandataire: **Bonnet, Michel**
**Cabinet Bonnet**
**93, rue Réaumur**
**75002 Paris (FR)**

(56) Documents cités:
**EP-A1- 1 830 450**        **EP-A2- 2 840 675**
**WO-A1-2010/118550**    **WO-A1-2011/076242**
**US-A1- 2014 180 616**

**Description**

La présente invention concerne une installation de surveillance d'une portion de réseau de transmission de courant électrique à haute tension.

Elle porte plus précisément sur une installation comportant :

- plusieurs postes électriques locaux de raccordement de lignes à haute tension disposés à chacun d'une pluralité de noeuds de la portion de réseau, chaque poste électrique local étant électriquement raccordé à au moins une extrémité de ligne à haute tension et implémentant un premier protocole de communication dédié à une communication interne entre dispositifs électriques qu'il comporte, et
- au moins un site distant de surveillance relié à chacun des postes électriques locaux par un réseau de téléconduite implémentant un deuxième protocole de communication dédié à cette téléconduite.

La téléconduite prévoit la transmission de données de télécommande, du ou des sites distants de surveillance vers chacun des postes électriques locaux, et de données de télésignalisation et télémesure, des postes électriques locaux vers le ou les sites distants de surveillance, pour une gestion, pilotée par des opérateurs, de l'état de la portion de réseau. En particulier, chaque poste électrique local dispose d'un mécanisme automatisé de détection du dépassement d'au moins une capacité maximale locale de transport de courant électrique dans la ou les lignes à haute tension qui lui sont raccordées. En remontant cette information vers le ou les sites distants de surveillance, on permet non seulement une gestion locale automatisée de ce type de dépassement, mais également un agissement plus global sur la portion de réseau, par exemple pour commander des effacements de production, des délestages de consommation ou des interruptions de transits sur ligne à haute tension. Les documents EP1830450 et EP2840675 divulguent cet état de la technique.

Malheureusement, il n'est pas possible avec ce type d'infrastructure de disposer sur site distant de toutes les informations disponibles dans chacun des postes électriques locaux de la portion de réseau. Les actions résultantes sont donc limitées.

Par ailleurs, certaines décisions à prendre en cas de congestion du réseau, par exemple lors de pics de production ou de consommation, sont lourdes de conséquences alors qu'elles peuvent nécessiter une forte réactivité des opérateurs du ou des sites de surveillance. Les risques d'actions non conformes ou n'exploitant pas de façon optimale les capacités réelles de la portion de réseau sont donc accrus.

Il peut ainsi être souhaité de prévoir une installation de surveillance d'une portion de réseau de transmission de courant électrique à haute tension qui permette de s'affranchir d'au moins une partie des problèmes et contraintes précités.

Il est donc proposé une installation de surveillance d'une portion de réseau de transmission de courant électrique à haute tension, comportant :

- plusieurs postes électriques locaux de raccordement de lignes à haute tension disposés à chacun d'une pluralité de noeuds de la portion de réseau, chaque poste électrique local étant électriquement raccordé à au moins une extrémité de ligne à haute tension et implémentant un premier protocole de communication dédié à une communication interne entre dispositifs électriques qu'il comporte,
- au moins un site distant de surveillance relié à chacun des postes électriques locaux par un réseau de téléconduite implémentant un deuxième protocole de communication dédié à cette téléconduite,

dans laquelle :

- l'un des postes électrique locaux, dit poste électrique principal, comporte des moyens automatisés de surveillance supplémentaire configurés pour recevoir, traiter et transmettre des données conformes au premier protocole de communication,
- ce poste électrique principal est relié à chacun des autres postes électriques locaux par un réseau de surveillance supplémentaire, distinct du réseau de téléconduite, implémentant le premier protocole de communication.

Ainsi, grâce à une telle installation, on exploite avantageusement en réseau toutes les informations codées conformément au premier protocole de communication et dédiées initialement à des échanges internes à chaque poste électrique local, non visibles depuis le site distant de surveillance. En dirigeant ces informations vers l'un des postes électriques locaux qui est lui-même configuré pour recevoir, traiter et transmettre des données codées conformément à ce premier protocole, et en dotant ce poste électrique de moyens automatisés de surveillance supplémentaire, on permet un renforcement et une amélioration de la surveillance de la portion de réseau.

De façon optionnelle, les moyens de surveillance supplémentaire du poste électrique principal comportent :

- des moyens de stockage d'un modèle de la portion de réseau, ce modèle comportant des points singuliers et au moins une ligne conductrice de courant électrique à haute tension entre ces points singuliers, d'une relation d'équilibre thermique prédéterminée, d'une température limite de fonctionnement de chaque ligne conductrice et de paramètres de conduction de chaque ligne conductrice,
- un calculateur, ayant accès aux moyens de stockage, programmé pour une détermination dynamique de capacités maximales optimisées de transport de courant électrique dans les lignes à haute tension de la portion de réseau à partir de la relation d'équilibre thermique prédéterminée, de chaque température limite de fonctionnement, de chaque paramètre de conduction de réseau et de paramètres météorologiques, et

- des moyens de transmission des capacités maximales optimisées aux postes électriques locaux respectivement concernés conformément au premier protocole de communication.

De façon optionnelle également, chaque poste électrique local comporte :

- un mécanisme de surveillance locale de dépassement d'au moins une valeur de capacité maximale locale, et
- un automate de surveillance supplémentaire locale associé à une mémoire locale et configuré pour :

  • recevoir et stocker en mémoire locale chaque valeur de capacité maximale optimisée relative à une ligne à haute tension dont une extrémité est électriquement raccordée à ce poste électrique local,
  • comparer chaque valeur de capacité maximale optimisée reçue et stockée à ladite au moins une valeur de capacité maximale locale, et
  • remplacer le mécanisme de surveillance locale par un mécanisme de surveillance optimisée de dépassement d'au moins une valeur de capacité maximale optimisée stockée en mémoire locale sous certaines conditions prédéterminées.

De façon optionnelle également :

- chaque poste électrique local comporte une passerelle configurée pour transcoder des données de télécommande conformes au deuxième protocole de communication en signaux de télécommande exploitables en interne par chaque poste électrique local et pour transcoder des signaux de télésignalisation et télémesure émis en interne par chaque poste électrique local en données de télésignalisation et télémesure conformes au deuxième protocole de communication,
- chaque passerelle comporte des moyens supplémentaires de transcodage des données conformes au deuxième protocole de communication en données conformes au premier protocole de communication, un port de communication avec les dispositifs électriques que comporte le poste électrique local dans lequel elle est installée et un port d'accès au réseau de surveillance supplémentaire, et
- chaque passerelle est configurée pour transmettre au poste électrique principal, via le réseau de surveillance supplémentaire, au moins une partie des données de télécommande, télésignalisation et télémesure transcodées conformément au premier protocole de communication avec d'autres données provenant des dispositifs électriques que comporte le poste électrique local dans lequel elle est installée.

De façon optionnelle également, l'automate de surveillance supplémentaire locale de chaque poste électrique local et sa mémoire locale associée sont implémentés dans la passerelle de ce poste électrique local.

De façon optionnelle également, les moyens automatisés de surveillance supplémentaire sont implémentés dans la passerelle du poste électrique principal.

De façon optionnelle également, le poste électrique principal comporte des moyens automatisés de détection, localisation et traitement de défauts dans la portion de réseau à partir des données transmises par chaque passerelle via le réseau de surveillance supplémentaire.

De façon optionnelle également, le poste électrique principal comporte des moyens automatisés de gestion d'un encombrement de la portion de réseau à partir des données transmises par chaque passerelle via le réseau de surveillance supplémentaire, cette gestion comportant l'émission de requêtes d'effacements modulés de production, de délestages de consommation ou d'interruptions de transits sur ligne à haute tension.

De façon optionnelle également, les moyens automatisés de détection, localisation et traitement de défauts ainsi que les moyens automatisés de gestion d'un encombrement sont implémentés dans les moyens de surveillance supplémentaire du poste électrique principal.

De façon optionnelle également :

- le premier protocole de communication est conforme à la norme IEC 61850, et
- le deuxième protocole de communication est conforme à la norme IEC 60870-5, notamment IEC 60870-5-104.

L'invention sera mieux comprise à l'aide de la description qui va suivre, donnée uniquement à titre d'exemple et faite en se référant aux dessins annexés dans lesquels :

- la figure 1 représente schématiquement la structure générale d'une installation de surveillance d'une portion de réseau de transmission de courant électrique à haute tension, selon un mode de réalisation de l'invention,
- la figure 2 représente schématiquement la structure générale de moyens automatisés de surveillance supplémentaire disposés dans l'un des postes électriques locaux de l'installation de la figure 1,
- la figure 3 représente schématiquement et partiellement une structure de poste électrique local de l'installation de la figure 1, et

- la figure 4 illustre les étapes successives d'un procédé de surveillance mis en oeuvre par l'installation de la figure 1.

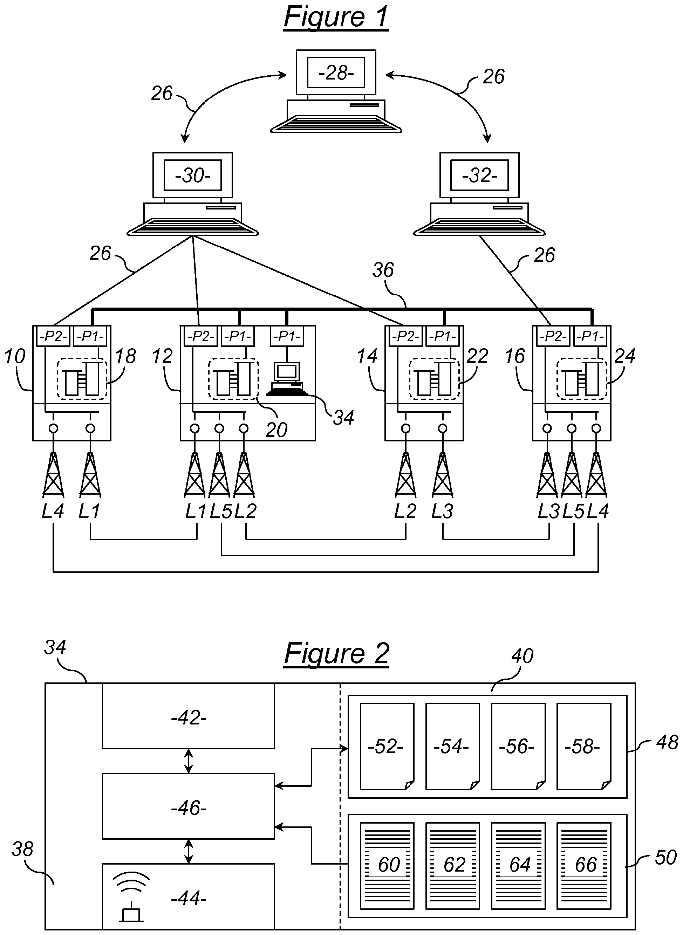

L'installation illustrée schématiquement sur la figure 1 comporte plusieurs postes électriques locaux formant les noeuds d'une portion de réseau de transmission de courant électrique à haute tension. Chaque poste électrique local est électriquement raccordé à au moins une extrémité de ligne à haute tension de la portion de réseau. Chaque ligne à haute tension est une ligne de transmission ou de distribution de courant électrique et s'étend d'un poste électrique local à un autre de la portion de réseau en étant portée par des pylônes.

Dans cet exemple particulier non limitatif, la portion de réseau 10 comporte quatre postes électriques locaux 10, 12, 14 et 16, chacun étant défini, par la Commission Electrotechnique Internationale IEC (de l'anglais « International Electrotechnical Commission »), comme une « partie d'un réseau électrique, située en un même lieu, comprenant principalement les extrémités des lignes de transport ou de distribution, de l'appareillage électrique, des bâtiments, et, éventuellement, des transformateurs ». Un poste électrique local est donc un élément du réseau de transmission de courant électrique servant à la fois à la transmission et à la distribution d'électricité. Il permet d'élever la tension électrique pour sa transmission à haute tension, et de la redescendre en vue de sa consommation par des utilisateurs (particuliers ou industriels). La disposition relative des quatre postes électriques locaux 10, 12, 14 et 16 est quelconque et ne correspond pas à l'illustration dans laquelle ils sont alignés par commodité. Ils forment les quatre sommets d'un quadrilatère quelconque dont chaque côté peut mesurer plusieurs kilomètres voire dizaines de kilomètres.

Dans cet exemple particulier non limitatif également, la portion de réseau comporte une ligne à haute tension L1 s'étendant entre le poste 10 et le poste 12, une ligne à haute tension L2 s'étendant entre le poste 12 et le poste 14, une ligne à haute tension L3 s'étendant entre le poste 14 et le poste 16, une ligne à haute tension L4 s'étendant entre le poste 16 et le poste 10 et une ligne à haute tension L5 s'étendant entre le poste 12 et le poste 16.

Le poste électrique local 10 comporte un certain nombre de dispositifs électriques symbolisés par la référence 18. Ces dispositifs sont connus en soi et ne seront pas détaillés. Ils sont interconnectés et gérés en local à l'aide d'un premier protocole de communication dédié, généralement un protocole conforme à la norme IEC 61850. De même : le poste électrique local 12 comporte un certain nombre de dispositifs électriques symbolisés par la référence 20, interconnectés et gérés en local à l'aide du même premier protocole de communication ; le poste électrique local 14 comporte un certain nombre de dispositifs électriques symbolisés par la référence 22, interconnectés et gérés en local à l'aide du même premier protocole de communication ; et le poste électrique local 16 comporte un certain nombre de dispositifs électriques symbolisés par la référence 24, interconnectés et gérés en local à l'aide du même premier protocole de communication.

L'installation illustrée schématiquement sur la figure 1 comporte par ailleurs au moins un site distant de surveillance relié à chacun des postes électriques locaux 10, 12, 14 et 16 par un réseau de téléconduite 26 implémentant un deuxième protocole de communication dédié à cette téléconduite. Il peut s'agir d'un protocole de communication conforme à la norme IEC 60870-5, notamment IEC 60870-5-104. Trois sites distants 28, 30 et 32 sont représentés à titre d'exemple selon une arborescence à deux niveaux. Un site distant de surveillance générale 28 communique avec deux sites distants de surveillance secondaire 30, 32 eux-mêmes directement raccordés à des postes électriques locaux. Le site distant de surveillance secondaire 30 est ainsi en communication directe avec les postes électriques locaux 10, 12 et 14 de la portion de réseau illustrée tandis que le site distant de surveillance secondaire 32 est en communication directe avec le poste électrique local 16, ces communications étant conformes au deuxième protocole pour de la téléconduite.

Conformément à l'invention, une surveillance supplémentaire est assurée par l'un des postes électriques locaux, en l'occurrence le poste 12 qui comporte des moyens automatisés de surveillance supplémentaire 34 configurés pour recevoir, traiter et transmettre des données conformes au premier protocole de communication. Ces moyens 34 peuvent prendre la forme d'un ordinateur. D'une façon plus générale, ils comportent un calculateur associé à des moyens de stockage de données de traitement et de programmes d'ordinateur. Pour cela, le poste 12 est qualifié de poste électrique principal. Il est relié à chacun des autres postes électriques locaux 10, 14 et 16 par un réseau de surveillance supplémentaire 36, distinct du réseau de téléconduite 26, implémentant le premier protocole de communication.

Ainsi, chaque poste électrique local est pourvu d'une passerelle comportant un port d'accès P1 au réseau de surveillance supplémentaire 36, permettant des échanges conformes au premier protocole de communication entre postes électriques locaux, et un port d'accès P2 au réseau de téléconduite 26, permettant des échanges conformes au deuxième protocole de communication entre les sites distants de surveillance 28, 30, 32 et chaque poste électrique local. Le poste électrique principal 12 peut comporter un deuxième port d'accès P1 au réseau de surveillance supplémentaire 36 pour ses moyens automatisés de surveillance supplémentaire 34. En variante, ces derniers peuvent aussi avoir accès au réseau de surveillance supplémentaire 36 par le même port d'accès P1 que les dispositifs électriques 20.

Les moyens automatisés de surveillance supplémentaire 34 du poste principal 12 sont fonctionnellement détaillés sur la figure 2 selon un mode de réalisation possible de l'invention. Ils sont plus précisément conçus pour :

- une détermination et une gestion dynamiques de capacités maximales optimisées de transport de courant électrique relatives à la portion de réseau considérée,
- une détection, une localisation et un traitement automatisés de défauts dans la portion de réseau à partir de données transmises via le réseau de surveillance supplémentaire 36, et
- une gestion automatisée d'un encombrement de la portion de réseau à partir de données transmises également via le réseau de surveillance supplémentaire 36, cette gestion comportant l'émission de requêtes d'effacements modulés de production, de délestages de consommation ou d'interruptions de transits sur ligne à haute tension.

De façon avantageuse mais optionnelle, ils réalisent la détermination dynamique des capacités maximales optimisées à partir de valeurs de vitesses de vent qu'ils reçoivent régulièrement en temps réel, par exemple à partir de mesures relevées par un ensemble de stations anémométriques déployées autour de la portion de réseau.

Ces moyens 34 sont mis en oeuvre dans un dispositif informatique tel qu'un ordinateur classique et comportent alors une unité de traitement 38 associée à une mémoire 40 (par exemple une mémoire RAM) pour le stockage de fichiers de données et de programmes d'ordinateurs.

L'unité de traitement 38 comporte une interface 42 conforme au premier protocole de communication et apte à être connectée à l'un des ports d'accès P1 du poste électrique principal 12. Elle comporte en outre optionnellement un récepteur 44 de valeurs de vitesses de vent fournies régulièrement (par exemple par ondes hertziennes) et un calculateur 46, par exemple un microprocesseur, apte à traiter les valeurs fournies par l'interface 42 et le récepteur 44.

La mémoire 40 est partitionnée en une première zone 48 de stockage de données de traitement et une deuxième zone 50 de stockage de programmes d'ordinateur. Cette partition est purement fonctionnelle, choisie pour une présentation claire des moyens 34, mais ne reflète pas nécessairement l'organisation réelle de la mémoire 40.

La première zone de stockage 48 comporte tout d'abord des données 52 relatives à un modèle de la portion de réseau considérée, ce modèle comportant des points singuliers, incluant notamment les noeuds que constituent les postes électriques locaux 10, 12, 14, 16, et au moins une ligne conductrice de courant électrique à haute tension entre ces points singuliers. Ces données comprennent des paramètres d'identification et de caractérisation des points singuliers et des lignes conductrices du modèle, incluant, outre les considérations topologiques ou géographiques, une température limite de fonctionnement et des paramètres de conduction pour chaque ligne conductrice.

La première zone de stockage 48 comporte en outre des données 54 relatives à une relation d'équilibre thermique prédéterminée. Cette relation est par exemple une équation mathématique équilibrant au moins des expressions mathématiques de gains par effet Joule et énergie solaire avec des expressions mathématiques de pertes par convection et rayonnement électromagnétique. Il peut notamment s'agir d'une relation issue de l'équation IEEE en régime permanent, définie dans le document intitulé « IEEE standard for calculating the current-temperature relationship of bare overhead conductors », publié par IEEE Power Engineering Society sous la référence IEEE Std 738™-2006, en janvier 2007. Il peut aussi s'agir d'une relation issue de l'équation Cigré en régime permanent, définie dans le document intitulé « Thermal behaviour of overhead conductors », publié par le comité d'étude « B2-lignes aériennes » de l'organisation Cigré, WG 22.12, en août 2002, ou précisée dans le document intitulé « Guide for thermal rating calculations of overhead lines », publié par le comité d'étude « B2-lignes aériennes » de l'organisation Cigré, WG B2.43, en décembre 2014. Elle prend par exemple la forme générale :

$$P_J + P_S = P_C + P_R \,,$$

où $P_J$ est le gain thermique par effet Joule, $P_S$ le gain thermique par énergie solaire, $P_C$ la perte thermique par convection et $P_R$ la perte thermique par rayonnement électromagnétique. On se reportera vers les documents cités ci-dessus pour des exemples d'expressions détaillées de chacun(e) de ces gains ou pertes.

La première zone de stockage 48 comporte en outre des données 56 relatives à des paramètres météorologiques généraux portant sur la zone géographique dans laquelle se trouve la portion de réseau considérée. Ces paramètres peuvent être choisis a priori comme les plus défavorables possibles dans l'environnement de la portion de réseau. Ils peuvent relever de zonages, calculs statistiques, mesures régulières, etc. Ils comportent par exemple des valeurs de température ambiante et d'ensoleillement qui sont fonction du lieu et de la saison.

La première zone de stockage 48 comporte enfin de façon optionnelle des données 58 relatives à un modèle de propagation de vent. De nombreux modèles de propagation plus ou moins sophistiqués sont connus. Il peut par exemple s'agir d'un modèle de projection linéaire proportionnel selon lequel la vitesse de propagation est prise arbitrairement égale à la l'amplitude de la vitesse du vent, tandis que le sens de la propagation, considérée comme plane, est celui du vent. Un tel modèle, particulièrement simple, est loin d'être parfait, mais il est déjà susceptible de fournir de bons résultats pour une estimation dynamique des capacités maximales optimisées mentionnées précédemment. Il permet de construire un historique des valeurs de vitesse de vent pour chaque point du modèle 52 de la portion de réseau, et notamment pour chaque point singulier. Un tel historique s'enrichit progressivement au gré des mesures de vitesses de vent.

La deuxième zone de stockage 50 telle qu'illustrée sur la figure 1 comporte fonctionnellement quatre programmes d'ordinateurs ou quatre fonctions d'un même programme d'ordinateur 60, 62, 64, 66. On notera en effet que les programmes d'ordinateurs 60, 62, 64, 66 sont présentés comme distincts, mais cette distinction est purement fonctionnelle. Ils pourraient tout aussi bien être regroupés selon toutes les combinaisons possibles en un ou plusieurs logiciels. Leurs fonctions pourraient aussi être au moins en partie micro programmées ou micro câblées dans des circuits intégrés dédiés. Ainsi, en variante, le dispositif informatique mettant en oeuvre l'unité de traitement 38 et sa mémoire 40 pourrait être remplacé par un dispositif électronique composé uniquement de circuits numériques (sans programme d'ordinateur) pour la réalisation des mêmes actions.

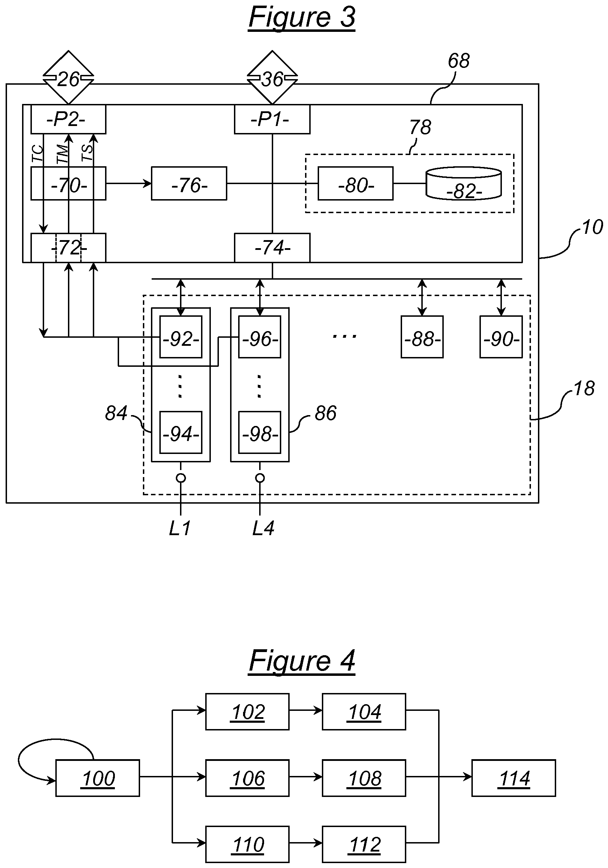

Le premier programme d'ordinateur 60 comporte des lignes d'instructions pour l'application du modèle 58 de propagation de vent depuis au moins l'une des stations anémométriques d'où sont issues les mesures de vitesses de vent vers les points singuliers du modèle 52 de portion de réseau, pour une estimation de valeurs successives de vitesses de vent en chaque point singulier à partir de valeurs successives de vitesses de vent mesurées. Un exemple non limitatif de fonctionnement de ce premier programme sera détaillé en référence à la figure 4.

Le deuxième programme d'ordinateur 62 comporte des lignes d'instructions pour l'exécution du calcul d'au moins une valeur de capacité maximale optimisée de transport de courant électrique en chaque point singulier du modèle 54 de portion de réseau, et notamment en chaque nœud de la portion de réseau, à partir :

- de la relation d'équilibre thermique prédéterminée 54,
- de chaque température limite de fonctionnement et de chaque paramètre de conduction de réseau enregistrés avec les données du modèle 52 de la portion de réseau, et
- des paramètres météorologiques généraux 56,

en prenant en compte, dans la relation d'équilibre thermique prédéterminée 54, les valeurs de vitesses de vent estimées en tous les points singuliers par exécution du premier programme 60.

Plus précisément et conformément à l'enseignement du document « Guide for thermal rating calculations of overhead lines » précédemment cité, les valeurs de vitesses de vent peuvent être prises en compte dans l'expression mathématique de perte par convection

$P_C$ de l'expression $P_J + P_S = P_C + P_R$.

Dans l'exemple de la figure 1, ce sont deux valeurs de capacités maximales optimisées qui peuvent être calculées au point singulier que constitue le poste électrique local 10, l'une pour la ligne à haute tension L1, l'autre pour la ligne à haute tension L4. Trois valeurs de capacités maximales optimisées peuvent être calculées au point singulier que constitue le poste électrique local 12, l'une pour la ligne à haute tension L1, une autre pour la ligne à haute tension L2, la dernière pour la ligne à haute tension L5. Deux valeurs de capacités maximales optimisées peuvent être calculées au point singulier que constitue le poste électrique local 14, l'une pour la ligne à haute tension L2, l'autre pour la ligne à haute tension L3. Trois valeurs de capacités maximales optimisées peuvent être calculées au point singulier que constitue le poste électrique local 16, l'une pour la ligne à haute tension L3, une autre pour la ligne à haute tension L4, la dernière pour la ligne à haute tension L5.

Le calculateur 46 est alors configuré pour transmettre les capacités maximales optimisées aux postes électriques locaux respectivement concernés via son interface 42, le port d'accès P1 du poste électrique principal 12 et le réseau de surveillance supplémentaire 36, conformément au premier protocole de communication.

Le troisième programme d'ordinateur 64 comporte des lignes d'instructions pour l'exécution de la détection, de la localisation et du traitement automatisés de défauts dans la portion de réseau à partir de données transmises via le réseau de surveillance supplémentaire 36.

Le quatrième programme d'ordinateur 66 comporte des lignes d'instructions pour l'exécution de la gestion automatisée d'un encombrement de la portion de réseau à partir de données transmises via le réseau de surveillance supplémentaire 36.

Les éléments, utiles à la compréhension de l'invention, de l'un quelconque des postes électriques locaux 10, 12, 14, 16 sont illustrés sur la figure 3. Le poste 10 est plus précisément pris en exemple.

Il comporte l'ensemble 18 des dispositifs électriques ainsi qu'une passerelle 68 configurée pour permettre un échange de données avec le réseau de téléconduite 26.

La passerelle 68 comporte ainsi le port d'accès P2 via lequel elle reçoit des données de télécommande TC émises par le site distant 30 et émet des données de télésignalisation TS ou télémesure TM vers ce site distant 30, toutes ces données étant conformes au deuxième protocole de communication. Elle comporte en outre un premier transcodeur 70 pour le transcodage des données de télécommande TC en signaux de télécommande exploitables en interne par le poste électrique local 10 et pour le transcodage de signaux de télésignalisation ou télémesure émis en interne par les dispositifs électriques 18 en données de télésignalisation TS ou télémesure TM. Elle comporte en outre au moins trois cartes électroniques d'interface 72 avec les dispositifs électriques 18 pour l'échange des signaux de télécommande, télésignalisation et télémesure avec eux.

Par ailleurs, la passerelle 68 comporte le port P1 d'accès au réseau de surveillance supplémentaire 36 via lequel elle échange des données conformes au premier protocole de communication. Elle comporte en outre un port 74 de communication avec les dispositifs électriques 18 selon ce même premier protocole de communication, ainsi qu'un deuxième transcodeur 76 pour le transcodage des données TC, TS et TM conformes au deuxième protocole de communication en données conformes au premier protocole de communication. Elle est alors configurée pour transmettre au poste électrique principal 12, via le réseau de surveillance supplémentaire 36, au moins une partie des données de télécommande TC, télésignalisation TS et télémesure TM transcodées conformément au premier protocole de communication avec d'autres données provenant des dispositifs électriques 18.

Enfin, la passerelle 68 comporte un système de surveillance supplémentaire locale 78, par exemple un dispositif informatique, comportant un automate 80 associé à une mémoire locale 82 et pouvant se substituer, au moins temporairement, à un mécanisme de surveillance locale qui va maintenant être détaillé.

Les dispositifs électriques 18 du poste électrique local 10 comportent en effet un dispositif 84 de surveillance de la ligne à haute tension L1 et un dispositif 86 de surveillance de la ligne à haute tension L4, de même que d'autres dispositifs 88, 90, etc. qui ne seront pas détaillés parce que tout à fait classiques dans un poste électrique local. Tous ces dispositifs peuvent échanger des données avec la passerelle 68 grâce au port 74 et un bus de communication dédié.

Le dispositif 84 met en oeuvre le mécanisme de surveillance locale en comportant un automate 92 de protection de la ligne à haute tension L1 associé à une mémoire 94 stockant une valeur de capacité maximale locale prédéfinie, indiquant de façon statique une valeur de surcharge à ne pas dépasser, cette valeur pouvant dépendre de la saison ou d'autres paramètres. Cet automate 92 est conçu, par application de certaines règles prédéfinies localement ou sur réception de signaux de télécommande spécifiques, pour déclencher certaines actions de protection de la ligne à haute tension L1 dans certaines circonstances préétablies. Ces actions peuvent notamment comporter une coupure de la ligne L1. L'automate 92 est plus généralement conçu pour échanger des signaux de télécommande, télésignalisation et télémesure avec les trois cartes électroniques d'interface 72.

Le dispositif 86 met en oeuvre le mécanisme de surveillance locale de la même façon en comportant un automate 96 de protection de la ligne à haute tension L4 associé à une mémoire 98 stockant une valeur de capacité maximale locale prédéfinie, indiquant de façon statique une valeur de surcharge à ne pas dépasser, cette valeur pouvant dépendre de la saison ou d'autres paramètres. Cet automate 96 est conçu, par application de certaines règles prédéfinies localement ou sur réception de signaux de télécommande spécifiques, pour déclencher certaines actions de protection de la ligne à haute tension L4 dans certaines circonstances préétablies. Ces actions peuvent notamment comporter une coupure de la ligne L4. L'automate 96 est plus généralement conçu pour échanger lui aussi des signaux de télécommande, télésignalisation et télémesure avec les trois cartes électroniques d'interface 72.

L'automate de surveillance supplémentaire locale 80 est configuré pour recevoir et stocker en mémoire locale 82 toute valeur de capacité maximale optimisée calculée par les moyens automatisés de surveillance supplémentaire 34 du poste électrique principal 12 pour la ligne à haute tension L1 ou L4. Il est en outre configuré pour comparer chaque valeur de capacité maximale optimisée reçue et stockée en mémoire locale 82 à la valeur de capacité maximale locale correspondante stockée en mémoire 94 ou 98. Il est enfin configuré pour remplacer le mécanisme de surveillance locale 92, 96 par un mécanisme de surveillance optimisée de dépassement des valeurs de capacités maximales optimisées stockée en mémoire locale 82 pour les lignes L1 et L4 sous certaines conditions prédéterminées. Ces conditions sont par exemple définies sur la base de contraintes liées aux mesures à partir desquelles ont été calculées les capacités maximales optimisées (vitesses minimales de vent, cohérence des mesures, ...), sur un indice de confiance relatif aux capacités maximales optimisées reçues, ou sur toute autre considération classique laissée à l'appréciation de l'homme du métier.

Les postes électriques locaux 14 et 16 sont structurés de la même façon que celui qui vient d'être détaillé ci-dessus. En ce qui concerne le poste électrique principal 12, il comporte en outre les moyens automatisés de surveillance supplémentaire 34 qui peuvent être implémentés dans le même dispositif informatique que celui qui implémente le système de surveillance supplémentaire locale 78. En variante, ils peuvent être implémentés dans un dispositif informatique dédié hors de la passerelle 68, raccordé au port 74 par bus de communication ou à son propre port d'accès P1 comme illustré sur la figure 1.

Sur la figure 4, un exemple non limitatif de fonctionnement des moyens automatisés de surveillance supplémentaire 34 du poste électrique principal 12 est illustré.

Au cours d'une étape 100 de récolte de données, l'interface 42 conforme au premier protocole de communication et le récepteur 44 reçoivent et fournissent au calculateur 46 toutes les données nécessaires aux traitements évoqués précédemment :

- des valeurs de vitesses de vent fournies par des stations anémométriques pour une estimation en temps réel des vitesses de vents aux noeuds de la portion de réseau considérée,

- des données de télécommande TC, télésignalisation TS ou télémesure TM transcodées en données conformes au premier protocole de communication, provenant de chacun des postes électriques locaux 10, 14 et 16 via le réseau de surveillance supplémentaire 36, ou fournies en interne dans le poste électrique principal 12,
- des données provenant des dispositifs électriques 18, 20, 22, 24, conformes au premier protocole de communication et transitant par le réseau de surveillance supplémentaire 36 en ce qui concerne les dispositifs électriques 18, 22 et 24 des postes électriques locaux 10, 14 et 16.

Cette étape de collecte de données s'exécute en boucle tant que les moyens automatisés de surveillance supplémentaire 34 restent opérationnels et sollicités.

Elle permet la réalisation d'une étape 102 de calcul de valeurs de capacités maximales optimisées pour chacune des lignes à haute tension L1 à L5, par exécution des premier et deuxième programmes d'ordinateur 60 et 62. A titre d'exemple non limitatif, cette étape 102 peut commencer par la sélection d'une station anémométrique sous le vent : un sens principal de vent est déterminé à partir des dernières valeurs de vitesses de vent reçues, par exemple par un calcul de moyenne angulaire des sens de vent mesurés par les différentes stations anémométriques, puis la station anémométrique sous le vent est sélectionnée, c'est-à-dire celle qui est située la plus en amont dans le sens principal de vent déterminé. Ensuite, sous certaines conditions de vitesses minimales et cohérences entre valeurs fournies, les vitesses de vent en chaque point souhaité de la portion de réseau sont estimées par projection temporelle en appliquant le modèle 58 de propagation de vent. Ensuite, ces vitesses de vent sont exploitées pour calculer les valeurs de capacités maximales optimisées par exécution du programme d'ordinateur 62. A la fin de cette étape, les valeurs obtenues sont respectivement transmises aux systèmes 78 de surveillance supplémentaire locale des postes électriques locaux concernés en transitant par le réseau de surveillance supplémentaire 36.

Au cours d'une étape suivante 104, elles sont localement appliquées le cas échéant, soit sur commande à distance des moyens automatisés de surveillance supplémentaire 34 du poste électrique principal 12, soit sur gestion locale des systèmes 78 (notamment en cas de panne du réseau de surveillance supplémentaire 36). Il est à la portée de l'homme du métier de programmer les moyens 34 ou les systèmes 78 pour que l'application des capacités maximales optimisées à la place des capacités maximales locales enregistrées en mémoires 94, 98 ou pour que le retour à ces capacités maximales locales se fasse intelligemment sans transition brutale.

L'étape 100 de collecte de données permet également la réalisation d'une étape 106 de détection, localisation et traitement de défauts dans la portion de réseau par exécution du troisième programme d'ordinateur 64. De nombreuses méthodes, mises en oeuvre par algorithmes et logiciels, sont déjà bien connues et ne seront pas détaillées. Les résultats de cette étape peuvent être transmis aux sites distants de surveillance 28, 30, 32 au cours d'une étape suivante 108 ou être traités directement par le calculateur 46 et/ou les automates 80.

L'étape 100 de collecte de données permet également la réalisation d'une étape 110 de gestion automatisée d'un ou plusieurs encombrements de la portion de réseau par exécution du quatrième programme d'ordinateur 66. En coopération avec la gestion des capacités maximales optimisées des étapes 102, 104, le calculateur 46 est programmé pour décider de certaines actions à mener de manière à résorber un encombrement détecté. De telles actions peuvent être transmises par le réseau de surveillance supplémentaire 36 et exécutées localement au cours d'une étape suivante 112: requêtes d'effacements de production, de délestages de consommation ou d'interruptions de transits sur certaines lignes à haute tension. En particulier, les requêtes d'effacement de production peuvent être modulées en effacement partiels strictement nécessaires et suffisants pour faire disparaître les contraintes temporaires grâce à la gestion intelligente des capacités maximales des lignes à haute tension.

Les étapes 104, 108 et 112 sont suivies d'une étape 114 de fin de fonctionnement des moyens automatisés de surveillance supplémentaire 34 du poste électrique principal 12 lorsqu'ils ne sont plus sollicités ou opérationnels.

Il apparaît clairement qu'une installation telle que celle décrite précédemment permet une surveillance améliorée d'une portion de réseau de transmission de courant électrique à haute tension, de manière à permettre son exploitation à pleine capacité sans besoin de renforcement du réseau de transport.

On notera par ailleurs que l'invention n'est pas limitée au mode de réalisation décrit précédemment. Il apparaîtra en effet à l'homme de l'art que diverses modifications peuvent être apportées au mode de réalisation décrit ci-dessus, à la lumière de l'enseignement qui vient de lui être divulgué. Les revendications définissent la protection recherchée.

## Revendications

1. Installation de surveillance d'une portion de réseau de transmission de courant électrique à haute tension, comportant :

   - plusieurs postes électriques locaux (10, 12, 14, 16) de raccordement de lignes à haute tension (L1, L2, L3, L4, L5) disposés à chacun d'une pluralité de noeuds de la portion de réseau, chaque poste électrique local étant électriquement raccordé à au moins une extrémité de ligne à haute tension et implémentant un premier protocole de communication dédié à une communication interne entre dispositifs électriques (18, 20, 22, 24) qu'il comporte,

- au moins un site distant de surveillance (28, 30, 32) relié à chacun des postes électriques locaux (10, 12, 14, 16) par un réseau de téléconduite (26) implémentant un deuxième protocole de communication dédié à cette téléconduite,

**caractérisée en ce que** :

- l'un des postes électrique locaux (10, 12, 14, 16), dit poste électrique principal (12), comporte des moyens automatisés de surveillance supplémentaire (34) configurés pour recevoir, traiter et transmettre des données conformes au premier protocole de communication pour gérer de manière dynamique la portion de réseau,

- ce poste électrique principal (12) est relié à chacun des autres postes électriques locaux (10, 14, 16) par un réseau de surveillance supplémentaire (36), distinct du réseau de téléconduite (26), implémentant le premier protocole de communication.

2. Installation de surveillance selon la revendication 1, dans laquelle les moyens de surveillance supplémentaire (34) du poste électrique principal (12) comportent :

- des moyens (48) de stockage d'un modèle (52) de la portion de réseau, ce modèle comportant des points singuliers et au moins une ligne conductrice de courant électrique à haute tension entre ces points singuliers, d'une relation (54) d'équilibre thermique prédéterminée, d'une température limite de fonctionnement de chaque ligne conductrice et de paramètres de conduction de chaque ligne conductrice,

- un calculateur (46), ayant accès aux moyens de stockage (48), programmé (60, 62) pour une détermination dynamique de capacités maximales optimisées de transport de courant électrique dans les lignes à haute tension (L1, L2, L3, L4, L5) de la portion de réseau à partir de la relation d'équilibre thermique prédéterminée (54), de chaque température limite de fonctionnement, de chaque paramètre de conduction de réseau et de paramètres météorologiques (56), et

- des moyens 42, 46) de transmission des capacités maximales optimisées aux postes électriques locaux (10, 12, 14, 16) respectivement concernés conformément au premier protocole de communication.

3. Installation de surveillance selon la revendication 2, dans laquelle chaque poste électrique local (10, 12, 14, 16) comporte :

- un mécanisme (92, 94, 96, 98) de surveillance locale de dépassement d'au moins une valeur de capacité maximale locale, et

- un automate (80) de surveillance supplémentaire locale associé à une mémoire locale (82) et configuré pour :

• recevoir et stocker en mémoire locale (82) chaque valeur de capacité maximale optimisée relative à une ligne à haute tension dont une extrémité est électriquement raccordée à ce poste électrique local,

• comparer chaque valeur de capacité maximale optimisée reçue et stockée à ladite au moins une valeur de capacité maximale locale, et

• remplacer le mécanisme de surveillance locale (92, 94, 96, 98) par un mécanisme de surveillance optimisée de dépassement d'au moins une valeur de capacité maximale optimisée stockée en mémoire locale (82) sous certaines conditions prédéterminées.

4. Installation de surveillance selon l'une quelconque des revendications 1 à 3, dans laquelle :

- chaque poste électrique local (10, 12, 14, 16) comporte une passerelle (68) configurée (70) pour transcoder des données de télécommande (TC) conformes au deuxième protocole de communication en signaux de télécommande exploitables en interne par chaque poste électrique local et pour transcoder des signaux de télésignalisation (TS) et télémesure (TM) émis en interne par chaque poste électrique local en données de télésignalisation et télémesure conformes au deuxième protocole de communication,

- chaque passerelle (68) comporte des moyens supplémentaires (76) de transcodage des données (TC, TS, TM) conformes au deuxième protocole de communication en données conformes au premier protocole de communication, un port (74) de communication avec les dispositifs électriques que comporte le poste électrique local dans lequel elle est installée et un port (P1) d'accès au réseau de surveillance supplémentaire (36), et

- chaque passerelle (68) est configurée pour transmettre au poste électrique principal (12), via le réseau de surveillance supplémentaire (36), au moins une partie des données de télécommande (TC), télésignalisation (TS) et télémesure (TM) transcodées conformément au premier protocole de communication avec d'autres données provenant des dispositifs électriques que comporte le poste électrique local dans lequel elle est installée.

5. Installation de surveillance selon les revendications 3 et 4, dans laquelle l'automate de surveillance supplémentaire locale (80) de chaque poste électrique local et sa mémoire locale associée (82) sont implémentés dans la passerelle (68) de ce poste électrique local.

6. Installation de surveillance selon la revendication 4 ou 5, dans laquelle les moyens automatisés de surveillance supplémentaire (34) sont implémentés dans la passerelle (68) du poste électrique principal (12).

7. Installation de surveillance selon l'une quelconque des revendications 4 à 6, dans laquelle le poste électrique principal (12) comporte des moyens automatisés (46, 64) de détection, localisation et traitement de défauts dans la portion de réseau à partir des données transmises par chaque passerelle (64) via le réseau de surveillance supplémentaire (36).

8. Installation de surveillance selon l'une quelconque des revendications 4 à 6, dans laquelle le poste électrique principal (12) comporte des moyens automatisés (46, 66) de gestion d'un encombrement de la portion de réseau à partir des données transmises par chaque passerelle (64) via le réseau de surveillance supplémentaire (36), cette gestion comportant l'émission de requêtes d'effacements modulés de production, de délestages de consommation ou d'interruptions de transits sur ligne à haute tension.

9. Installation de surveillance selon les revendications 7 et 8, dans laquelle les moyens automatisés (46, 64) de détection, localisation et traitement de défauts ainsi que les moyens automatisés (46, 66) de gestion d'un encombrement sont implémentés dans les moyens de surveillance supplémentaire (34) du poste électrique principal (12).

10. Installation de surveillance selon l'une quelconque des revendications 1 à 9, dans laquelle :

    - le premier protocole de communication est conforme à une première norme, et
    - le deuxième protocole de communication est conforme à une seconde norme différente de la première norme.

**Patentansprüche**

1. Einrichtung zur Überwachung eines Abschnitts eines Hochspannungs-Stromübertragungsnetzes, umfassend:

    - mehrere lokale Umspannwerke (10, 12, 14, 16) zum Anschließen von Hochspannungsleitungen (L1, L2, L3, L4, L5), die an jedem aus einer Vielzahl von Knoten des Netzabschnitts angeordnet sind, wobei jedes lokale Umspannwerk an mindestens ein Ende der Hochspannungsleitung elektrisch angeschlossen ist und ein erstes Kommunikationsprotokoll implementiert, das einer internen Kommunikation zwischen elektrischen Vorrichtungen (18, 20, 22, 24), welche es umfasst, vorbehalten ist,
    - mindestens eine ferne Überwachungsstelle (28, 30, 32), die über ein Fernwirknetz (26), das ein diesem Fernwirken vorbehaltenes zweites Kommunikationsprotokoll implementiert, mit jedem der lokalen Umspannwerke (10, 12, 14, 16) verbunden ist,

    **dadurch gekennzeichnet, dass**:

    - eines der lokalen Umspannwerke (10, 12, 14, 16), das als Hauptumspannwerk (12) bezeichnet wird, zusätzlichen automatisierte Überwachungsmittel (34) umfasst, die dafür konfiguriert sind, Daten, die dem ersten Kommunikationsprotokoll entsprechen, zu empfangen, zu verarbeiten und zu übertragen, um den Netzabschnitt dynamisch zu verwalten,
    - dieses Hauptumspannwerk (12) über ein zusätzliches Überwachungsnetz (36), das von dem das erste Kommunikationsprotokoll implementierenden Fernwirknetz (26) getrennt ist, mit jedem der anderen lokalen Umspannwerke (10, 14, 16) verbunden ist.

2. Überwachungseinrichtung nach Anspruch 1, wobei die zusätzlichen Überwachungsmittel (34) des Hauptumspannwerks (12) umfassen:

    - Mittel (48) zum Speichern eines Modells (52) des Netzabschnitts, wobei dieses Modell einzelne Punkte und mindestens eine Leitung umfasst, die zwischen diesen einzelnen Punkten Hochspannungsstrom leitet, einer vorbestimmten thermischen Gleichgewichtsbeziehung (54), einer Betriebsgrenztemperatur jeder leitenden Leitung und von Leitungsparametern jeder leitenden Leitung,
    - einen auf die Speichermittel (48) Zugriff besitzenden Rechner (46), der für eine dynamische Bestimmung von optimierten maximalen Stromtragfähigkeiten in den Hochspannungsleitungen (L1, L2, L3, L4, L5) des Netzabschnitts auf Grundlage der vorbestimmten thermischen Gleichgewichtsbeziehung (54), jeder Betriebsgrenztemperatur, jedes Netzleitungsparameters und von meteorologischen Parametern (56) programmiert (60, 62) ist, und

- Mittel (42, 46) zum Übertragen der optimierten maximalen Fähigkeiten an die jeweils betroffenen lokalen Umspannwerke (10, 12, 14, 16) entsprechend dem ersten Kommunikationsprotokoll.

3. Überwachungseinrichtung nach Anspruch 2, wobei jedes lokale Umspannwerk (10, 12, 14, 16) umfasst:

- einen Mechanismus (92, 94, 96, 98) zur lokalen Überwachung von Überschreitung mindestens eines lokalen maximalen Fähigkeitswerts, und
- einen Automaten (80) zur zusätzlichen lokalen Überwachung, der einem lokalen Speicher (82) zugeordnet und dafür konfiguriert ist:

- jeden optimierten maximalen Fähigkeitswert, der sich auf eine Hochspannungsleitung bezieht, von der ein Ende elektrisch an dieses lokale Umspannwerk angeschlossen ist, zu empfangen und im lokalen Speicher (82) zu speichern,
- jeden empfangenen und gespeicherten optimierten maximalen Fähigkeitswert mit dem mindestens einen lokalen maximalen Fähigkeitswert zu vergleichen, und
- unter gewissen vorbestimmten Bedingungen den lokalen Überwachungsmechanismus (92, 94, 96, 98) durch einen Mechanismus zur optimierten Überwachung von Überschreitung mindestens eines optimierten maximalen Fähigkeitswerts, der im lokalen Speicher (82) gespeichert ist, zu ersetzen.

4. Überwachungseinrichtung nach einem der Ansprüche 1 bis 3, wobei:

- jedes lokale Umspannwerk (10, 12, 14, 16) ein Gateway (68) umfasst, das dafür konfiguriert (70) ist, Fernsteuerungsdaten (TC), die dem zweiten Kommunikationsprotokoll entsprechen, in Fernsteuerungssignale umzuwandeln, die intern von jedem lokalen Umspannwerk genutzt werden können, und dafür, Fernsignalisierungs- (TS) und Fernmesssignale (TM), die von jedem lokalen Umspannwerk intern gesendet werden, in Fernsignalisierungs- und Fernmesssignale umzuwandeln, die dem zweiten Kommunikationsprotokoll entsprechen,
- jedes Gateway (68) zusätzliche Mittel (76) zum Umwandeln der Daten (TC, TS, TM), die dem zweiten Kommunikationsprotokoll entsprechen, in Daten, die dem ersten Kommunikationsprotokoll entsprechen, einen Port (74) zur Kommunikation mit den elektrischen Vorrichtungen, die das lokale Umspannwerk, in dem dasselbe eingerichtet ist, umfasst, und einen Port (P1) für Zugriff auf das zusätzliche Überwachungsnetz (36) umfasst, und

- jedes Gateway (68) dafür konfiguriert ist, mindestens einen Teil der Fernsteuerungs- (TC), Fernsignalisierungs- (TS) und Fernmesssignale (TM), die entsprechend dem ersten Kommunikationsprotokoll umgewandelt wurden, mit weiteren Daten, die von den elektrischen Vorrichtungen stammen, welche das lokale Umspannwerk, in dem dasselbe eingerichtet ist, enthält, über das zusätzliche Überwachungsnetz (36) an das Hauptumspannwerk (12) zu übertragen.

5. Überwachungseinrichtung nach den Ansprüchen 3 und 4, wobei der zusätzliche lokale Überwachungsautomat (80) jedes lokalen Umspannwerks und der ihm zugeordnete lokale Speicher (82) im Gateway (68) dieses lokalen Umspannwerks implementiert sind.

6. Überwachungseinrichtung nach Anspruch 4 oder 5, wobei die zusätzlichen automatisierten Überwachungsmittel (34) im Gateway (68) des Hauptumspannwerks (12) implementiert sind.

7. Überwachungseinrichtung nach einem der Ansprüche 4 bis 6, wobei das Hauptumspannwerk (12) automatisierte Mittel (46, 64) zum Erkennen, Lokalisieren und Verarbeiten von Störungen im Netzabschnitt auf Grundlage der von jedem Gateway (64) über das zusätzliche Überwachungsnetz (36) übertragenen Daten umfasst.

8. Überwachungseinrichtung nach einem der Ansprüche 4 bis 6, wobei das Hauptumspannwerk (12) automatisierte Mittel (46, 66) zum Verwalten einer Überlastung des Netzabschnitts auf Grundlage der von jedem Gateway (64) über das zusätzliche Überwachungsnetz (36) übertragenen Daten umfasst, wobei dieses Verwalten das Senden von Anfragen bezüglich modulierter Produktionssteuerung, bezüglich Lastabwurf von Verbrauchern oder bezüglich Unterbrechungen von Durchleitungen auf einer Hochspannungsleitung umfasst.

9. Überwachungseinrichtung nach den Ansprüchen 7 und 8, wobei die automatisierten Mittel (46, 64) zum Erkennen, Lokalisieren und Verarbeiten von Störungen, sowie die automatisierten Mittel (46, 66) zum Verwalten einer Überlastung in den zusätzlichen Überwachungsmitteln (34) des Hauptumspannwerks (12) implementiert sind.

10. Überwachungseinrichtung nach einem der Ansprüche 1 bis 9, wobei:

- das erste Kommunikationsprotokoll einer ersten Norm entspricht, und
- das zweite Kommunikationsprotokoll einer zweiten Norm entspricht, die sich von der ersten Norm unterscheidet.

**Claims**

1. A facility for monitoring a portion of a high-voltage electrical power transmission network comprising:

   - several local electrical substations (10, 12, 14, 16) for connection of high voltage lines (L1, L2, L3, L4, L5), located at each of a plurality of nodes of the network portion, each local electrical substation being electrically connected to at least one high voltage line end and implementing a first communication protocol dedicated to internal communication between electrical devices (18, 20, 22, 24) that it contains,
   - at least one remote monitoring site (28, 30, 32) connected to each of the local electrical substations (10, 12, 14, 16) by a remote control network (26) implementing a second communication protocol dedicated to this remote control,

   **characterized in that**:

   - one of the local electrical substations (10, 12, 14, 16), called the main electrical substation (12), comprises additional automated monitoring means (34) configured to receive, process and transmit data conforming with the first communication protocol for dynamically managing the network portion,
   - this main electrical substation (12) is connected to each of the other local electrical substations (10, 14, 16) by an additional monitoring network (36), distinct from the remote control network (26), implementing the first communication protocol.

2. The monitoring facility as claimed in claim 1, wherein the additional monitoring means (34) of the main electrical substation (12) comprise:

   - means (48) for storing a model (52) of the network portion, this model containing singular points and at least one high-voltage electrical power conducting line between these singular points, a predetermined thermal equilibrium relation (54), a limit operating temperature for each conducting line and conduction parameters for each conducting line,
   - a computer (46) with access to the storing means (48), programmed (60, 62) for dynamic determination of optimized maximum capacities for electrical power transmission in high-voltage lines (L1, L2, L3, L4, L5) in the network portion starting from the predetermined thermal equilibrium relation (54), each limit operating temperature, each network conduction parameter and meteorological parameters (56), and
   - means (42, 46) for transmission of the optimized maximum capacities to the respectively concerned local electrical substations (10, 12, 14, 16) in accordance with the first communication protocol.

3. The monitoring facility as claimed in claim 2, wherein each local electrical substation (10, 12, 14, 16) comprises:

   - a mechanism (92, 94, 96, 98) for local monitoring when at least one local maximum capacity value is exceeded, and
   - a programmable logic controller (80) for additional local monitoring associated with a local memory (82) and configured to:

     • receive and store each optimized maximum capacity value related to a high-voltage line, one end of which is electrically connected to this local electrical substation, in local memory (82),
     • compare each received and stored optimized maximum capacity value with said at least one local maximum capacity value, and
     • replace the local monitoring mechanism (92, 94, 96, 98) by a mechanism for optimized monitoring of exceedance of at least one optimized maximum capacity value stored in local memory (82) under specific predetermined conditions.

4. The monitoring facility as claimed in any one of claims 1 to 3, wherein:

   - each local electrical substation (10, 12, 14, 16) comprises a gateway (68) configured (70) to transcode remote control (TC) data conforming with the second communication protocol into remote control signals that can be used internally by each local electrical substation and to transcode remote signalling (TS) and remote measurement (TM) signals transmitted internally by each local electrical substation into remote signalling and remote measurement data conforming with the second communication protocol,
   - each gateway (68) comprises additional means (76) for transcoding data (TC, TS, TM) conforming with the second communication protocol into data conforming with the first communication protocol, a communication port (74) with the electrical devices contained in the local electrical substation in which it is installed and an access port (P1) to the additional monitoring network (36), and

- each gateway (68) is configured to transmit at least some of the remote control (TC), remote signaling (TS) and remote measurement (TM) data transcoded according to the first communication protocol with other data originating from the electrical devices contained in the local electrical substation in which it is installed, to the main electrical substation (12) through the additional monitoring network (36).

5. The monitoring facility as claimed in claims 3 and 4, wherein the programmable logic controller (80) for additional local monitoring in each local electrical substation and its associated local memory (82) are implemented in the gateway (68) of this local electrical substation.

6. The monitoring facility as claimed in claim 4 or 5, wherein the additional automated monitoring means (34) are implemented in the gateway (68) of the main electrical substation (12).

7. The monitoring facility as claimed in any one of claims 4 to 6, wherein the main electrical substation (12) comprises automated means (46, 64) for detection, positioning and processing of faults in the network portion starting from data transmitted by each gateway (64) through the additional monitoring network (36).

8. The monitoring facility as claimed in any one of claims 4 to 6, wherein the main electrical substation (12) comprises automated means (46, 66) for management of congestion of the network portion starting from data transmitted by each gateway (64) through the additional monitoring network (36), this management including emission of requests for modulated production curtailment, consumption load shedding or transit interruptions on high-voltage line.

9. The monitoring facility as claimed in claims 7 and 8, wherein the automated means (46, 64) for detection, positioning and processing of faults and the automated means (46, 66) for management of congestion are implemented in the additional monitoring means (34) of the main electrical substation (12).

10. The monitoring facility as claimed in any one of claims 1 to 9, wherein:

- the first communication protocol complies with a first standard, and
- the second communication protocol complies with a second standard different from the first standard.

## Figure 1

## Figure 2

## Figure 3

## Figure 4

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1830450 A
- EP 2840675 A

**Littérature non-brevet citée dans la description**

- IEEE standard for calculating the current-temperature relationship of bare overhead conductors. IEEE Power Engineering Society, Janvier 2007
- Thermal behaviour of overhead conductors. le comité d'étude « B2-lignes aériennes », Août 2002
- Guide for thermal rating calculations of overhead lines. le comité d'étude « B2-lignes aériennes », Décembre 2014